# EUROPEAN PATENT APPLICATION

(11) **EP 4 760 315 A1**
(43) Date of publication of application: **17.06.2026**
(21) Application number: 24903991.8
(22) Date of filing: 08.11.2024
(51) Int. Cl.: G01R 31/396, G01R 31/382, G01R 19/10, G01R 19/12, G01R 19/165

(54) **BATTERY DIAGNOSIS DEVICE, BATTERY DIAGNOSIS METHOD, AND BATTERY DIAGNOSIS SYSTEM**

(30) Priority: 13.12.2023 KR 20230180591; 27.09.2024 KR 20240131496
(71) Applicant: LG Energy Solution, Ltd., Seoul 07335 (KR)
(72) Inventor: IN, Jeong Hyeon, Daejeon 34122 (KR)
(74) Representative: Goddar, Heinz J.
(86) International application number: PCT/KR2024/017593
(87) International publication number: WO 2025/127424

(57) **Abstract**

According to some embodiments disclosed herein, a battery diagnosis apparatus includes an interface configured to obtain first battery measurement values from diagnosis target cells and a controller configured to select second battery measurement values satisfying an analysis condition from among the first battery measurement values, calculate battery deviation values based on a difference between a representative value of the second battery measurement values and each of the second battery measurement values, calculate an analysis indicator value indicating a change trend with respect to a measurement time of the battery deviation values, and diagnose states of the diagnosis target cells based on the analysis indicator values.

## Description

### TECHNICAL FIELD

### CROSS-REFERENCE TO RELATED APPLICATION

This application claims priority to and the benefit of Korean Patent Application No. 10-2024-0131496 filed in the Korean Intellectual Property Office on September 27, 2024, and Korean Patent Application No. 10-2023-0180591 filed in the Korean Intellectual Property Office on December 13, 2023, the entire contents of which are incorporated herein by reference.

### TECHNICAL FIELD

Embodiments disclosed herein relate to a battery diagnosis apparatus, a battery diagnosis method, and a battery diagnosis system.

### BACKGROUND ART

Recently, research and development of secondary batteries have been actively performed. Herein, the secondary batteries, which are chargeable/dischargeable batteries, may be interpreted as including all of conventional nickel (Ni)/cadmium (Cd) batteries, Ni/metal hydride (MH) batteries, etc., and recent lithium-ion batteries. Among secondary batteries, lithium-ion batteries may have a higher energy density than conventional Ni/Cd batteries, Ni/MH batteries, etc., and may be manufactured to be small and lightweight, allowing them to have high usability in terms of power sources for mobile devices. Recently, the lithium-ion battery is attracting attention as a next-generation energy storage medium as a usage range thereof is expanded to a power source of electric vehicles.

Voltage data of battery cells may be used to diagnose a state of a battery. For example, state diagnosis may be performed by calculating voltage deviation values indicating differences between cell voltage values and a cell average voltage and determining whether the voltage deviation values satisfy a specific diagnosis condition. However, such a diagnosis scheme may require a lot of computation to determine whether the specific diagnosis condition is satisfied, and the state of the battery may be diagnosed based on a point in time rather than a long-term behavior.

### DISCLOSURE

### TECHNICAL PROBLEM

Embodiments disclosed herein aim to provide a battery diagnosis apparatus, a battery diagnosis method, and a battery diagnosis system in which a state of a battery may be diagnosed based on a long-term behavior without requiring complex computation.

Technical problems of the embodiments disclosed herein are not limited to the above-described technical problems, and other unmentioned technical problems would be clearly understood by one of ordinary skill in the art from the following description.

### TECHNICAL SOLUTION

According to some embodiments disclosed herein, a battery diagnosis apparatus includes an interface configured to obtain first battery measurement values from diagnosis target cells and a controller configured to select second battery measurement values satisfying an analysis condition from among the first battery measurement values, calculate battery deviation values based on a difference between a representative value of the second battery measurement values and each of the second battery measurement values, calculate an analysis indicator value indicating a change trend with respect to a measurement time of the battery deviation values, and diagnose states of the diagnosis target cells based on the analysis indicator values.

According to some embodiments, the controller may be further configured to select open circuit voltage (OCV) measurement values from among the first battery measurement values and select OCV measurement values of at least a threshold voltage value as the second battery measurement values from among the OCV measurement values.

According to some embodiments, the controller may be further configured to calculate a moving average indicator indicating a long-term behavior of the battery deviation values over the measurement time.

According to some embodiments, the controller may be further configured to calculate an exponential moving average (EMA) of the battery deviation values to indicate the long-term behavior, and the long-term behavior may include a behavior of the battery deviation values in a period that is at least twice an analysis period of the EMA.

According to some embodiments, the controller may be further configured to calculate deviation slopes based on a variance of the EMA in the period that is at least twice the analysis period and diagnose the states of the diagnosis target cells based on the deviation slopes.

According to some embodiments, the controller may be further configured to detect a gap period in which there are no second battery measurement values satisfying the analysis condition among obtaining periods for obtaining the first battery measurement values and estimate analysis indicator values corresponding to the gap period by performing interpolation based on the analysis indicator values.

According to some embodiments, the diagnosis target cells may be included in a diagnosis target battery, and the diagnosis target battery may be mounted on a mobility device.

According to some embodiments disclosed herein, a battery diagnosis method includes obtaining first battery measurement values from diagnosis target cells, selecting second battery measurement values satisfying an analysis condition from among the first battery measurement values, calculating battery deviation values based on a difference between a representative value of the second battery measurement values and each of the second battery measurement values, calculating an analysis indicator value indicating a change trend with respect to a measurement time of the battery deviation values, and diagnosing states of the diagnosis target cells based on the analysis indicator values.

According to some embodiments, the selecting of the second battery measurement values may include selecting open circuit voltage (OCV) measurement values from among the first battery measurement values and selecting OCV measurement values of at least a threshold voltage value as the second battery measurement values from among the OCV measurement values.

According to some embodiments, the calculating of the analysis indicator values may include calculating a moving average indicator indicating a long-term behavior of the battery deviation values over the measurement time.

According to some embodiments, the calculating of the moving average indicator may include calculating an exponential moving average (EMA) of the battery deviation values to indicate the long-term behavior, and the long-term behavior may include a behavior of the battery deviation values in a period that is at least twice an analysis period of the EMA.

According to some embodiments, the diagnosing of the states of the diagnosis target cells may include calculating deviation slopes based on a variance of the EMA in the period that is at least twice the analysis period and diagnosing the states of the diagnosis target cells based on the deviation slopes.

According to some embodiments, the calculating of the analysis indicator values may include detecting a gap period in which there are no second battery measurement values satisfying the analysis condition among obtaining periods for obtaining the first battery measurement values and estimating analysis indicator values corresponding to the gap period by performing interpolation based on the analysis indicator values.

According to some embodiments, the diagnosis target cells may be included in a diagnosis target battery, and the diagnosis target battery may be mounted on a mobility device.

According to some embodiments disclosed herein, a battery diagnosis system includes a diagnosis target battery including diagnosis target cells and mounted on a power-using device and a battery diagnosis apparatus configured to obtain first battery measurement values from diagnosis target cells, select second battery measurement values satisfying an analysis condition from among the first battery measurement values, calculate battery deviation values based on a difference between a representative value of the second battery measurement values and each of the second battery measurement values, calculate an analysis indicator value indicating a change trend with respect to a measurement time of the battery deviation values, and diagnose states of the diagnosis target cells based on the analysis indicator values.

### ADVANTAGEOUS EFFECTS

According to embodiments disclosed herein, there may be provided a battery diagnosis apparatus, a battery diagnosis method, and a battery diagnosis system in which a state of a battery may be diagnosed based on a long-term behavior without requiring complex computation.

The technical effects according to embodiments disclosed in the present document are not limited to the effects mentioned above, and other effects not mentioned will be clearly understood by those of ordinary skill in the art according to the disclosure of the present document.

### DESCRIPTION OF DRAWINGS

FIG. 1 illustrates components of a battery diagnosis system according to some embodiments.
FIG. 2 illustrates components of a battery diagnosis apparatus according to some embodiments.
FIG. 3 shows a process of diagnosing abnormality of a diagnosis target battery according to a conventional art.
FIG. 4 shows a process of diagnosing abnormality of a diagnosis target battery according to some embodiments.
FIGS. 5 and 6 show a long-term behavior of a diagnosis target cell according to some embodiments.
FIG. 7 shows a process of analyzing an exponential moving average (EMA) according to some embodiments.
FIG. 8 shows a scheme to diagnose a defect of a battery cell by using a long-term behavior gradient according to some embodiments.
FIG. 9 shows a scheme to artificially induce a short-circuit in a battery cell according to some embodiments.
FIG. 10 shows correlation between a 240-day slope and an artificial defective cell according to some embodiments.
FIG. 11 illustrates operations of a battery diagnosis method according to some embodiments.

### MODE FOR INVENTION

Hereinafter, embodiments disclosed herein will be described with reference to the accompanying drawings. However, the description is not intended to limit the disclosure of the present document to particular embodiments, and it should be construed as including various modifications, equivalents, and/or alternatives according to the embodiments described herein.

It should be appreciated that embodiments of the present document and the terms used therein are not intended to limit the technological features set forth herein to a particular embodiment and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise.

As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. Such terms as "1st", "2nd," "first", "second", "A", "B", "(a)", or "(b)" may be used to simply distinguish a corresponding component from another, and does not limit the components in other aspect (e.g., importance or order), unless mentioned otherwise.

Herein, it is to be understood that when an element (e.g., a first element) is referred to, with or without the term "operatively" or "communicatively", as "connected with", "coupled with", or "linked with", or "coupled to" or "connected to" to another element (e.g., a second element), it means that the element may be connected with the other element directly (e.g., wiredly or wirelessly), or indirectly (e.g., via a third element).

A method according to various embodiments disclosed herein may be included and provided in a computer program product. The computer program product may be traded as a product between a seller and a buyer. In the case of online distribution, at least a part of a computer program product may be at least temporarily stored in a machine-readable storage medium such as a memory of a server of a manufacturer, a server of an application store, or a relay server, or may be generated temporarily. In the case of online distribution, at least a part of a computer program product may be at least temporarily stored in a machine-readable storage medium such as a memory of a server of a manufacturer, a server of an application store, or a relay server, or may be generated temporarily.

According to embodiments disclosed herein, each of the above-described components (e.g., a module or program) may include a single entity or a plurality of entities, some of which may be separately disposed on other components. According to embodiments disclosed herein, one or more of the above-described components or operations may be omitted, or one or more other components or operations may be added. Alternatively or additionally, a plurality of components (e.g., modules or programs) may be integrated into one component. In this case, the integrated component may perform one or more functions of each of the plurality of components in a manner that is the same as or similar to a corresponding component of the plurality of components before the integration. According to embodiments disclosed herein, operations performed by a module, a program, or other components may be executed sequentially, in parallel, repeatedly, or heuristically, or one or more of the operations may be executed in a different order or omitted, or one or more other operations may be added.

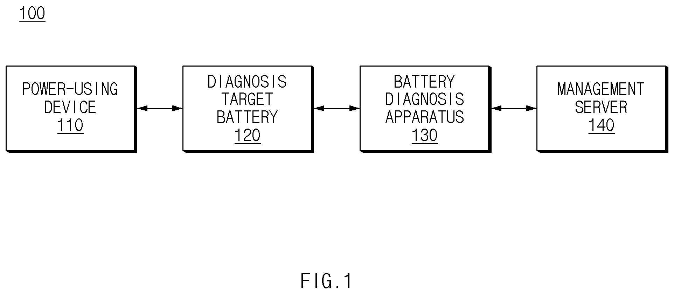

FIG. 1 illustrates components of a battery diagnosis system according to some embodiments.

Referring to FIG. 1, a battery diagnosis system 10 may include a power-using device 110, a diagnosis target battery 120, a battery diagnosis apparatus 130, and a management server 140. However, without being limited thereto, some components may be omitted from the battery diagnosis system 100 or other general-purpose components may be further included in the battery diagnosis system 100.

The battery diagnosis system 100 may refer to a system for diagnosing the diagnosis target battery 120. The diagnosis target battery 120 may be discharged or charged by the power-using device 110, and the battery diagnosis apparatus 130 may diagnose the diagnosis target battery 120 by analyzing data regarding charging and discharging of the diagnosis target battery 120.

The power-using device 110 may use the diagnosis target battery 120 as a power source. According to an embodiment, the power-using device 110 may include a mobility device such as an electric vehicle (EV), a hybrid EV (HEV), electric bike, etc. For example, the mobility device may discharge the diagnosis target battery 120 to drive a motor, and charge the diagnosis target battery 120 through regenerative breaking.

The diagnosis target battery 120 may include one or more battery packs. A battery pack of the diagnosis target battery 120 may include a plurality of battery modules, and each battery module may include a plurality of battery cells. According to an embodiment, the diagnosis target battery 120 may be mounted on the power-using device 110.

The battery diagnosis apparatus 130 may perform operations for diagnosing the diagnosis target battery 120. The battery diagnosis apparatus 130 may measure battery data from the diagnosis target battery 120 and diagnose a cell, a module, a pack, etc., of the diagnosis target battery 120 based on the battery data. According to an embodiment, the battery diagnosis apparatus 130 may diagnose whether a defect causing low-voltage energy or battery fire occurs in the diagnosis target battery 120 in the unit of a cell, a module, or a pack. According to an embodiment, the battery diagnosis apparatus 130 may be a battery management system (BMS) configured together with the diagnosis target battery 120.

According to an embodiment, the battery diagnosis apparatus 130 may include the BMS configured with the diagnosis target battery 120 in an on-board manner and/or an external device arranged remotely from the diagnosis target battery 120 in an off-board manner. The external device may include a charger of a charging station, a battery diagnosis apparatus, a cloud computing server, etc.

The management server 140 may manage a process and a result of diagnosis of the battery diagnosis apparatus 130. For example, the management server 140 may be a cloud computing server. The management server 140 may exchange data with the battery diagnosis apparatus 130 in a wired/wireless communication manner. When battery data is measured or a defect is diagnosed from the diagnosis target battery 120, corresponding results may be transmitted to the management server 140 and recorded in a database. According to an embodiment, the management server 140 may receive data for battery diagnosis and perform operations for diagnosing the diagnosis target battery 120 in place of the battery diagnosis apparatus 130. On the other hand, the battery diagnosis apparatus 130 may perform diagnosis operations by executing battery management software, and the management server 140 may provide update information of the battery management software to the battery diagnosis apparatus 130.

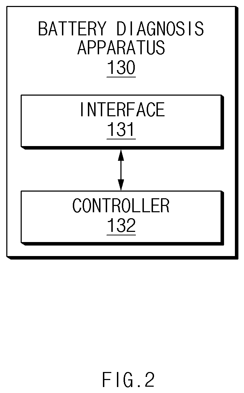

FIG. 2 illustrates components of a battery diagnosis apparatus according to some embodiments.

Referring to FIG. 2, the battery diagnosis apparatus 130 may include an interface 131 and a controller 132. However, without being limited thereto, some components may be omitted from the battery diagnosis apparatus 130 or other general-purpose components may be further included in the battery diagnosis apparatus 130.

According to an embodiment, the interface 131 and the controller 132 of the battery diagnosis apparatus 130 may be electrically connected to one another in a device-to-device communication manner. The device-to-device communication manner may include a general-purpose input and output (GPIO), a serial peripheral interface (SPI), a mobile industry processor interface (MIPI), etc.

The interface 131 may obtain the battery data of the diagnosis target battery 120. According to an embodiment, the interface 131 may include a communication unit configured to receive the battery data and/or a sensor unit configured to measure the battery data. According to an embodiment, when the battery diagnosis apparatus 130 is implemented in an off-board form, the communication unit may receive the battery data in a manner of wired data communication, wireless data communication, etc. When the battery diagnosis apparatus 130 is implemented in an on-board form, the sensor unit may be configured to measure values such as voltage, current, temperature, resistance, etc., from the diagnosis target battery 120.

For example, the sensor unit of the interface 131 may be configured to generate various battery measurement values from the diagnosis target battery 120. To this end, the sensor unit may include a measurement means such as a voltmeter, an ammeter, a thermometer, etc.

The controller 132 may have a structure for executing instructions that implement the operations of the battery diagnosis apparatus 130. The controller 132 may be implemented with an array of multiple logic gates or a general-purpose microprocessor for processing various operations, and may include a single processor or a plurality of processors. For example, the controller 132 may be implemented in the form of at least one of a microprocessor, a CPU, a GPU, and an AP.

The controller 132 may operate with a memory configured to store various data, instructions, mobile applications, computer programs, etc. The memory may be configured separately from or integrally with the controller 132. The controller 132 may execute instructions stored in the memory to process various calculation. For example, the memory may be implemented in the form of a non-volatile memory device such as ROM, PROM, EPROM, EEPROM, flash memory, PRAM, MRAM, RRAM, FRAM, etc., or a volatile memory device such as DRAM, SRAM, SDRAM, PRAM, etc., or a form such as HDD, SSD, SD, Micro- SD, etc., or may be implemented in the form of a combination thereof.

The interface 131 may be configured to obtain first battery measurement values from diagnosis target cells. The diagnosis target cells may be included in the diagnosis target battery 120. The first battery measurement values may include measurement values regarding cell current and cell voltage at a measurement point in time. Each first battery measurement value may correspond to each diagnosis target cell, and the first battery measurement values may be continuously collected every measurement intervals to constitute time-series data.

According to an embodiment, the first battery measurement values may include current values and voltage values measured from diagnosis target cells when the diagnosis target battery 120 is charged or discharged by the power-using device 110.

The controller 132 may be configured to select second battery measurement values that satisfy an analysis condition from among the first battery measurement values. The analysis condition may be applied to select values used for diagnosis of the battery diagnosis apparatus 130 from among the first battery measurement values. The analysis condition may be set based on the current value and the voltage value. According to an embodiment, OCV data having a current value of 0 and/or data having a voltage value of at least a specific value may be selected as second battery measurement values.

The controller 132 may be configured to calculate battery deviation values based on a difference between a representative value of the second battery measurement values and each second battery measurement value. The second battery measurement values may respectively correspond to diagnosis target cells, and the representative value of the second battery measurement values such as an average or a mean may be calculated. By subtracting the representative value from each second battery measurement value, battery deviation values respectively corresponding to the diagnosis target cells may be calculated. According to an embodiment, a deviation value of an OCV value corresponding to each diagnosis target cell may be calculated.

The controller 132 may be configured to calculate analysis indicators indicating a changing trend with respect to a measurement time of the battery deviation values. Like the first battery measurement value as described above, the second battery measurement value and the battery deviation value may be time-series data having a value at specific intervals. For example, each battery deviation value may be implemented in the form of a graph having a new value at specific intervals. An analysis indicator indicating a changing trend of each battery deviation value may be a technical analysis indicator such as a moving average (MA), an EMA, etc.

The controller 132 may be configured to diagnose states of diagnosis target cells based on the analysis indicators. For example, by analyzing a long-term behavior or trend of an analysis indicator of each diagnosis target cell, a state of the corresponding cell may be diagnosed. According to an embodiment, the long-term behavior or trend of the analysis indicator may be expressed in the form of a change rate or a graph slope with respect to a target period (e.g., 100 days, 240 days, etc.) of the corresponding indicator.

According to an embodiment, the controller 132 may be configured to select open circuit voltage (OCV) measurement values corresponding to a battery current of 0 from among the first battery measurement values and select second battery measurement values corresponding to a battery voltage of at least a threshold voltage from among the OCV measurement values. A voltage corresponding to a battery current of 0 may correspond to an OCV value measured in an open circuit state. For a cell having a maximum voltage of 4.3 V, the threshold voltage may be set to 3.9 V or 4.12 V, and the OCV measurement values having a voltage of at least the threshold voltage may be selected as the second battery measurement values. When there is no measurement value satisfying the current condition and/or voltage condition in a specific measurement period, the second battery measurement value may not be selected in the corresponding measurement period. To solve such a data gap, data interpolation may be used as described below.

According to an embodiment, the controller 132 may be configured to calculate a moving average indicator indicating a long-term behavior of battery deviation values over a measurement time. A moving average (MA) may also be referred to as a rolling average, a learning average, etc. The MA indicator may consider a recent data change and a previous data change together to reflect a long-term behavior. The analysis period of the MA may be set to 3 days, 5 days, 10 days, 15 days, 20 days, 30 days, 50 days, 100 days, 120 days, 150 days, 200 days, 240 days, 300 days, or other values. According to an embodiment, the long-term behavior may mean a behavior considering previous measurement values together instead of considering only the recent measurement value, and may be selected from a scheme to diagnose the diagnosis target battery 120 based on a measurement value at a measurement point in time.

According to an embodiment, the controller 132 may be configured to calculate the EMA of the battery deviation values to indicate the long-term behavior in which the long-term behavior may include a behavior of the battery deviation values for a period that is at least twice the analysis period of the EMA. A type of the MA indicator may include a simple MA, an accumulative MA, a weighted MA, etc., but the battery diagnosis apparatus 130 may use the EMA. For example, when the analysis period of the EMA is 10 days, a new EMA value may be calculated every 10 days. In this case, a change rate (slope) of the EMA value for 20 days that is at least twice 10 days may indicate the long-term behavior. Instead of 20 days, 30 days, 50 days, 80 days, 100 days, 120 days, 150 days, 200 days, 240 days, 300 days, or other values may be used.

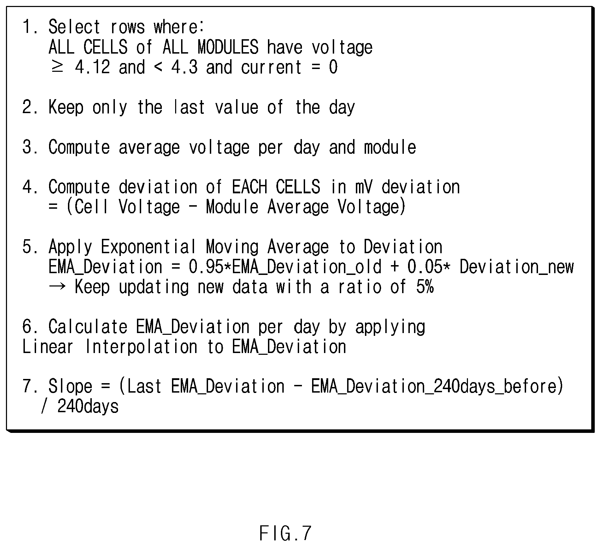

According to an embodiment, when the analysis period is 10 days, a new battery deviation value Deviation_new may be reflected as a rate of 5 % and an immediately previous EMA value EMA_Deviation_old may be reflected as a rate of 95 %, thereby calculating a new EMA value. This will be described with reference to FIG. 7 provided below. According to an embodiment, instead of 5 %, other values such as 1 %, 2 %, 3 %, 7 %, 8 %, 10 %, 12 %, 15 %, etc., may be used.

According to an embodiment, the controller 132 may be configured to calculate deviation slopes based on a variance of the EMA during a period that is at least twice the analysis period and diagnose the states of the diagnosis target cells based on the deviation slopes. For example, when the analysis period is 10 days, the variance (slope) of the EMA value for at least 20 days, e.g., 100 days or 240 days, may be calculated, and the corresponding slope value may be compared with a reference range, thereby diagnosing the states of the diagnosis target cells. For example, when an absolute value of a slope exceeds a threshold value in some cells, the corresponding cell may be diagnosed as a defect.

According to an embodiment, the controller 132 may be configured to detect a gap period in which there is no second battery measurement value that satisfies the analysis condition among obtaining periods for obtaining the first battery measurement values, and perform interpolation based on the analysis indicator values, thereby estimating analysis indicator values corresponding to the gap period. The obtaining periods for obtaining the first battery measurement values may be measurement periods for collecting the first battery measurement values. For example, when there is no value having a current value of 0 and a voltage value of at least 3.9 V among measurement values in a first measurement period, the first measurement period may be a gap period in which there is no second battery measurement value satisfying the analysis condition. For the gap period, there is none of the second battery measurement value, the battery deviation value, the EMA value, etc., such that interpolation for estimating them may be used. According to an embodiment, to estimate a value in the gap period, linear interpolation may be used.

According to an embodiment, the diagnosis target cells may be included in the diagnosis target battery 120, the diagnosis target battery 120 may be mounted on the power-using device 110, and the power-using device 110 may include a mobility device driven using the diagnosis target battery 120. For example, the mobility device may include an EV, an HEV, an electric bike, etc. The mobility device may discharge the diagnosis target battery 120 to drive a motor, and charge the diagnosis target battery 120 through regenerative breaking. In this process, the first battery measurement values of the diagnosis target battery 120 may be periodically collected.

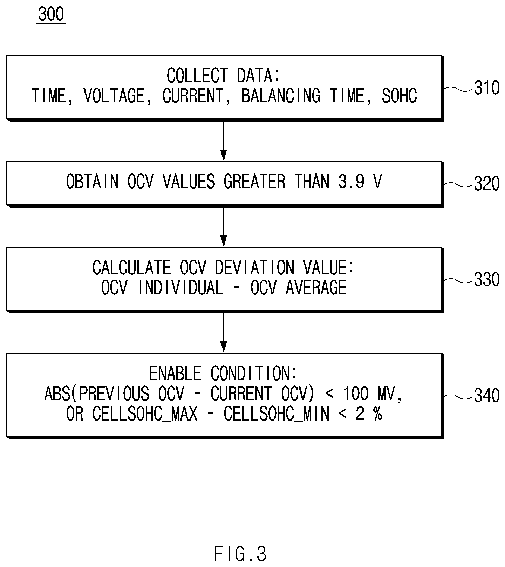

FIG. 3 shows a process of diagnosing abnormality of a diagnosis target battery according to a conventional art.

Referring to FIG. 3, a conventional art 300 for diagnosing abnormality of the diagnosis target battery 120 may be shown. In the conventional art 300, abnormality of the diagnosis target battery 120 may be diagnosed through operations 310 to 340.

In operation 310, battery data regarding time, voltage, current, balancing time, and SOHC may be collected. In this case, information requiring an additional processing process such as a balancing time, SOHC, etc., may be needed. In operation 320, OCV values greater than 3.9 V may be obtained. To extract the OCV values, it may be determined whether a current value is 0.

In operation 330, an OCV deviation value based on an OCV average may be calculated. In operation 340, an enable condition for diagnosing abnormality of the diagnosis target battery 120 based on the OCV deviation value, etc., may be determined. To determine whether the enable condition is satisfied, a process of determining whether a difference between a maximum value and a minimum value of the cell SOHC falls within a specific range, may be performed in addition to computation for the OCV deviation value. Thus, the conventional art 300 may be accompanied by a slightly complex process to battery diagnosis.

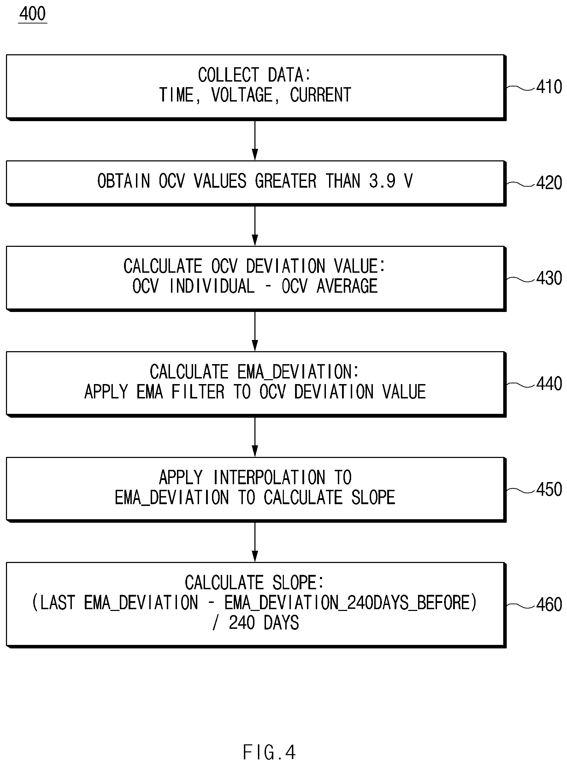

FIG. 4 shows a process of diagnosing abnormality of a diagnosis target battery according to some embodiments.

Referring to FIG. 4, a process of diagnosing abnormality of the diagnosis target battery 120 may include operations 410 to 460.

In operation 410, data such as time, voltage, current, etc., may be collected. In comparison with operation 310 of the conventional art 300, the balancing time, the SOHC, etc., requiring the additional processing process may not be needed. In operation 420, OCV values exceeding 3.9 V may be obtained, and to this end, voltage values having a current value of 0 may be compared with 3.9 V. In operation 430, an OCV deviation value using an OCV average may be calculated.

In operation 440, an EMA filter may be applied for the OCV deviation value. For example, the EMA value having an analysis period of 10 days may be calculated, and a graph plotting EMA values updated every 10 days may be generated for each cell. According to an embodiment, an EMA filter reflecting 5 % as a new EMA value and reflecting 95 % as an existing EMA value may be applied.

In operation 450, interpolation may be performed on the EMA value of the battery deviation value. For example, in calculation of a slope in the graph of the deviation EMA values, when the deviation EMA value is omitted at a specific point in time, interpolation may be performed to compensate for the omission. The omission of the deviation EMA value may occur when there is no measurement value having a current value of 0 and a voltage value of 3.9 V in operation 420.

In operation 460, the slope may be calculated in the graph of the deviation EMA values. For example, the slope may be calculated based on the variance of the deviation EMA value for 240 days and the slope may be compared with a diagnosis threshold value, thereby diagnosing a battery defect.

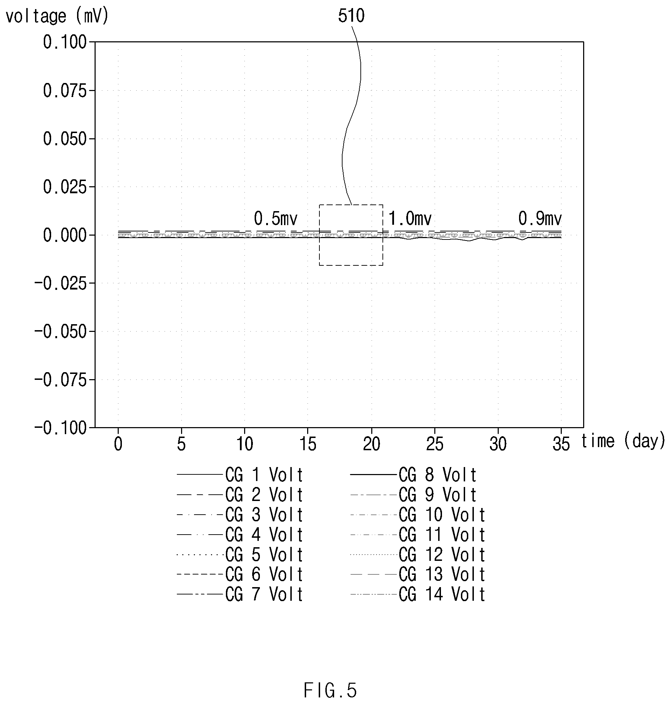

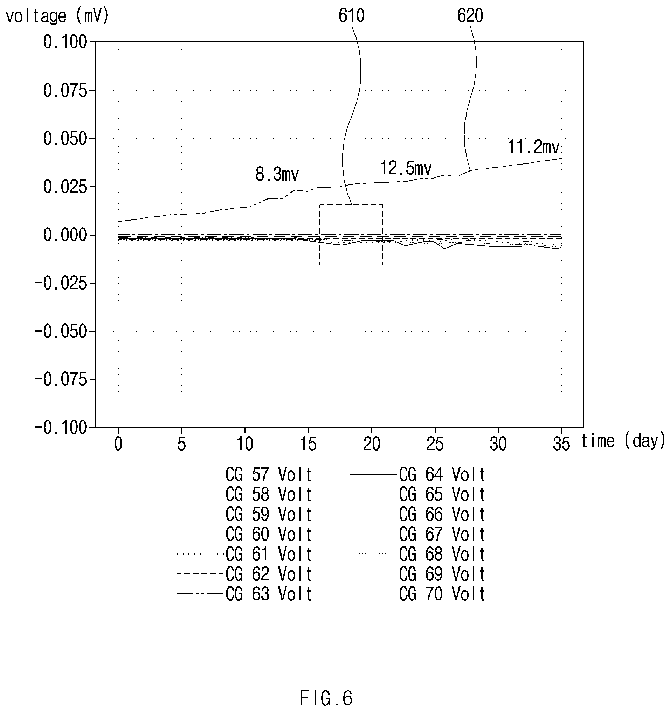

FIGS. 5 and 6 show a long-term behavior of a diagnosis target cell according to some embodiments.

Referring to FIGS. 5 and 6, a graph indicating a long-term behavior in a normal cell and a graph indicating a long-term behavior in an abnormal cell may be shown.

FIG. 5 shows 14 battery deviation values of 14 cells in a battery module including first through fourteenth cells. The battery deviation value may be an OCV deviation value. The battery module of FIG. 5 may include 14 normal cells, and battery deviation values 510 of the normal cells may be all close to 0. For example, as a result of calculating an OCV deviation value of a specific cell every 10 days, relatively low values such as 0.5 mV, 1.0 mV, 0.9 mV, etc., may be observed.

FIG. 6 shows 14 battery deviation values of 14 cells in a battery module including 57th through 70th cells. A battery deviation value 620 of an abnormal cell among the 14 cells may be away from the other values. For example, as a result of calculating an OCV deviation value of a specific cell every 10 days, relatively high values such as 8.3 mV, 12.5 mV, 11.2 mV, etc., may be observed. On the other hand, battery deviation values 610 of 13 normal cells may be maintained as being close to 0.

FIG. 7 shows a process of analyzing an exponential moving average (EMA) according to some embodiments.

Referring to FIG. 7, a pseudo code illustrating a process of analyzing the EMA may be shown. Seven processes of the pseudo code may correspond to operations 410 to 460 of FIG. 4.

In a process 1, OCV values having a current value of 0 may be selected from among all measurement values, and values exceeding 4.12 V may be selected from among the OCV values. A reference value of 4.12 V may be changed to other values such as 3.9 V, etc. In a process 2, last values of each day may be designated as a value representing the day. In a process 3 and a process 4, a deviation value based on an average may be calculated.

In a process 5, the EMA may be applied for a deviation value. For example, with an analysis period of 10 days, the current EMA value may be calculated using the current deviation value and the EMA value before 10 days. According to an embodiment, a rate reflecting the current deviation value may be 5 %, and may be changed to another value based on a battery diagnosis design.

In a process 6, when there is omitted data that fails to satisfy a condition of the process 1, data interpolation may be performed to compensate for the omitted data, which may be linear interpolation. In a process 7, the slope for the EMA values for 240 days may be calculated, and it may be diagnosed whether there is a defective cell by using the calculated slope.

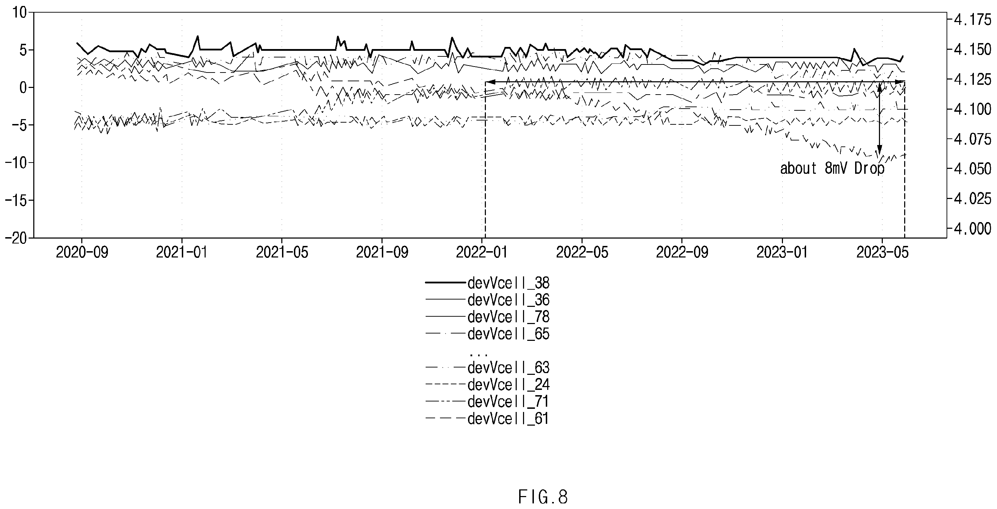

FIG. 8 shows a scheme to diagnose a defect of a battery cell by using a long-term behavior gradient according to some embodiments.

Referring to FIG. 8, a graph indicating a result of observing EMA values of battery cells over a long term may be shown.

FIG. 8 shows a long-term behavior of EMA values for 8 or more battery cells, among which for a 61st cell devVcell_61, a magnitude of an EMA slope may be greater than the other normal cells, considering a long-term trend.

For example, unlike other normal cells, for the 61st cell devVcell_61, over about 240 days from January in 2022 to May in 2023, a change of an EMA value close to 8 mV may occur. A magnitude of the change of 8 mV may exceed a threshold value for defect diagnosis. For example, a threshold value for defect diagnosis may be set to 3 mV, 4 mV, 5 mV, 6 mV, or other appropriate values based on 240 days.

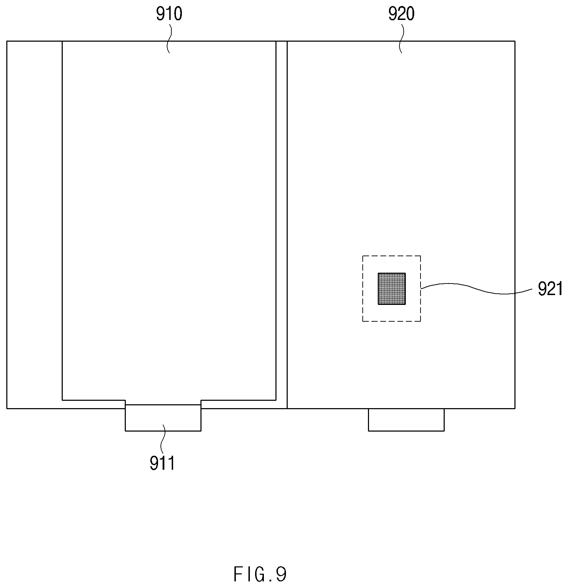

FIG. 9 shows a scheme to artificially induce a short-circuit in a battery cell according to some embodiments.

Referring to FIG. 9, an electrode plate 910 and a separator 920 are shown to describe a scheme to artificially induce a short-circuit in a battery cell. An electrode tab 911 may be formed on the electrode plate 910.

To make a battery cell defective by inducing a short-circuit between two electrode plates separated by the separator 920, an artificial damage 921 may be formed on the separator 920. For example, the damage 921 may be formed to have a size of 2 mm * 2 mm at a distance of 70 mm from a lower end of the separator 920 and at a distance of 70 mm from a right end of the separator 920. By using a battery cell having the artificial damage 921 formed thereon, the performance of a diagnosis scheme using the long-term behavior of the battery diagnosis apparatus 130 may be verified.

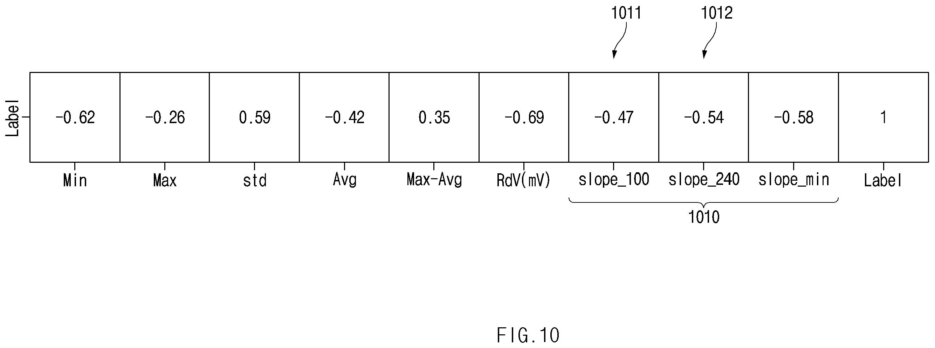

FIG. 10 shows correlation between a 240-day slope and an artificial defective cell according to some embodiments.

Referring to FIG. 10, a table for comparing performance of various defect diagnosis schemes by labelling a battery cell that artificially causes a defect as in FIG. 9 is shown.

The table of FIG. 10 may indicate correlation with a battery cell "Label" artificially causing a defect for various types of diagnosis criteria. According to an embodiment, the correlation of the table may be expressed in the form of a Pearson correlation coefficient. A degree of correlation of positive variables may be low for a value of the correlation closer to 0 and may be high for the value closer to ±1.

Among the diagnosis criteria of FIG. 10, slope criteria 1010 may be related to battery diagnosis using an EMA slope with respect to a battery deviation value. Among the slope criteria 1010, a first criterion 1011 having an analysis period of 100 days and a second criterion 1012 having an analysis period of 240 days may be related to a battery diagnosis scheme based on the long-term behavior.

For the first criterion 1011, a scheme to diagnose a cell defect using an EMA slope for 100 days may have a correlation of -0.47 in a relationship with an actual defective cell "Label". Likewise, for the second criterion 1012, a scheme to diagnose a cell defect using an EMA slope for 240 days may have a correlation of -0.54 in the relationship with the actual defective cell "Label". Thus, it may be seen that among schemes to diagnose a battery defect based on the long-term behavior, a scheme using a 240-day slope has higher performance than a scheme using the 240-day slope.

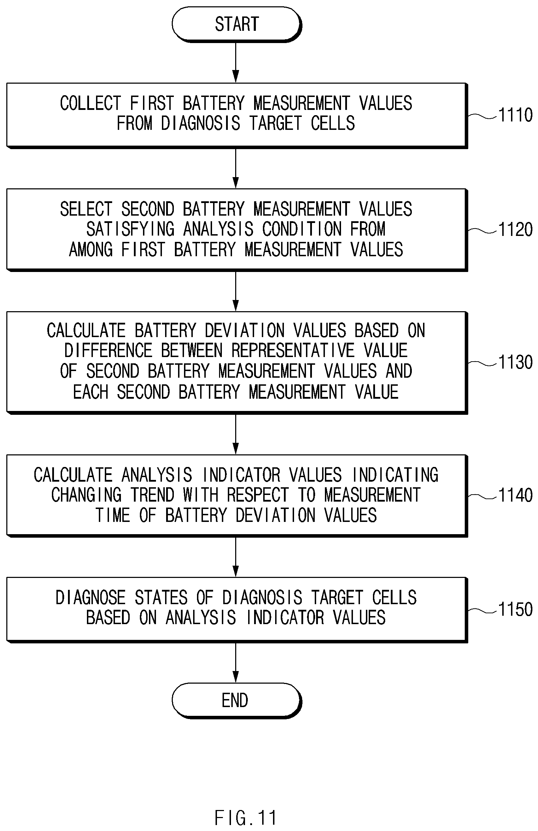

FIG. 11 illustrates operations of a battery diagnosis method according to some embodiments.

Referring to FIG. 11, a battery diagnosis method may include operations 1110 to 1150. However, without being limited thereto, some operations may be omitted and other general-purpose operations may be added, and operations of the battery diagnosis method may be executed in an order different from that shown.

The battery diagnosis method may include operations processed in time series by the battery diagnosis apparatus 130. Therefore, matters described for the battery diagnosis apparatus 130 above, even omitted below, may be equally applied to the battery diagnosis method.

Operations 1110 to 1150 of the battery diagnosis method may be performed by the interface 131 and the controller 132 of the battery diagnosis apparatus 130.

In operation 1110, the battery management apparatus 130 may obtain first battery measurement values from diagnosis target cells. In operation 1120, the battery diagnosis apparatus 130 may select second battery measurement values satisfying an analysis condition from among the first battery measurement values.

In operation 1130, the battery diagnosis apparatus 130 may calculate battery deviation values based on a difference between a representative value of the second battery measurement values and each second from among all measurement value. In operation 1140, the battery diagnosis apparatus 130 may calculate analysis indicator values indicating a changing trend with respect to a measurement time of the battery deviation values. In operation 1150, the battery diagnosis apparatus 130 may diagnose states of the diagnosis target cells based on the analysis indicator values.

According to an embodiment, the battery diagnosis method may be implemented in the form of a computer program stored in a computer-readable storage medium. That is, the computer program may include instructions for implementing the battery diagnosis method, and the instructions of the program may be stored in a computer-readable storage medium. The computer programs may include mobile applications.

According to an embodiment, the computer-readable storage medium may include magnetic media such as hard disk, floppy disk, and magnetic tape, optical media such as compact disk read only memory (CD-ROM) and digital versatile disk (DVD), magneto-optical media such as floptical disk, and a hardware device especially configured to store and execute program instructions, such as ROM, RAM and flash memory, etc. The computer program instructions may include a machine language code created by a complier and a high-level language code executable by a computer using an interpreter.

Terms such as "include", "constitute" or "have" described above may mean that the corresponding component may be inherent unless otherwise stated, and thus should be construed as further including other components rather than excluding other components. All terms including technical or scientific terms have the same meanings as those generally understood by those of ordinary skill in the art to which the embodiments disclosed herein pertain, unless defined otherwise. The terms used generally like terms defined in dictionaries should be interpreted as having meanings that are the same as the contextual meanings of the relevant technology and should not be interpreted as having ideal or excessively formal meanings unless they are clearly defined in this document.

The above description is merely illustrative of the technical idea disclosed herein, and various modifications and variations will be possible without departing from the essential characteristics of the embodiments disclosed herein by those of ordinary skill in the art to which the embodiments disclosed herein pertains. Therefore, the embodiments disclosed herein are intended for description rather than limitation of the technical spirit of the embodiments disclosed herein and the scope of the technical spirit of the present disclosure is not limited by these embodiments disclosed herein. The protection scope of the technical spirit disclosed herein should be interpreted by the following claims, and all technical spirits within the same range should be understood to be included in the range of this document.

### [Description of Reference Numerals]

| | | | |
|---|---|---|---|
| 100: | Battery Diagnosis System | 110: | Power-Using Device |
| 120: | Diagnosis Target Battery | 130: | Battery Diagnosis Apparatus |
| 131: | Interface | 132: | Controller |
| 140: | Management Server | | |

## Claims

1. A battery diagnosis apparatus comprising:
an interface configured to obtain first battery measurement values from diagnosis target cells; and
a controller configured to:
select second battery measurement values satisfying an analysis condition from among the first battery measurement values;
calculate battery deviation values based on a difference between a representative value of the second battery measurement values and each of the second battery measurement values;
calculate an analysis indicator value indicating a change trend with respect to a measurement time of the battery deviation values; and
diagnose states of the diagnosis target cells based on the analysis indicator values.

2. The battery diagnosis apparatus of claim 1, wherein the controller is further configured to:
select open circuit voltage (OCV) measurement values from among the first battery measurement values; and
select OCV measurement values of at least a threshold voltage value as the second battery measurement values from among the OCV measurement values.

3. The battery diagnosis apparatus of claim 1, wherein the controller is further configured to calculate a moving average indicator indicating a long-term behavior of the battery deviation values over the measurement time.

4. The battery diagnosis apparatus of claim 3, wherein the controller is further configured to calculate an exponential moving average (EMA) of the battery deviation values to indicate the long-term behavior, and
the long-term behavior comprises a behavior of the battery deviation values in a period that is at least twice an analysis period of the EMA.

5. The battery diagnosis apparatus of claim 4, wherein the controller is further configured to:
calculate deviation slopes based on a variance of the EMA in the period that is at least twice the analysis period; and
diagnose the states of the diagnosis target cells based on the deviation slopes.

6. The battery diagnosis apparatus of claim 1, wherein the controller is further configured to:
detect a gap period in which there are no second battery measurement values satisfying the analysis condition among obtaining periods for obtaining the first battery measurement values; and
estimate analysis indicator values corresponding to the gap period by performing interpolation based on the analysis indicator values.

7. The battery diagnosis apparatus of claim 1, wherein the diagnosis target cells are included in a diagnosis target battery, and the diagnosis target battery is mounted on a mobility device.

8. A battery diagnosis method comprising:
obtaining first battery measurement values from diagnosis target cells;
selecting second battery measurement values satisfying an analysis condition from among the first battery measurement values;
calculating battery deviation values based on a difference between a representative value of the second battery measurement values and each of the second battery measurement values;
calculating an analysis indicator value indicating a change trend with respect to a measurement time of the battery deviation values; and
diagnosing states of the diagnosis target cells based on the analysis indicator values.

9. The battery diagnosis method of claim 8, wherein the selecting of the second battery measurement values comprises:
selecting open circuit voltage (OCV) measurement values from among the first battery measurement values; and
selecting OCV measurement values of at least a threshold voltage value as the second battery measurement values from among the OCV measurement values.

10. The battery diagnosis method of claim 8, wherein the calculating of the analysis indicator values comprises calculating a moving average indicator indicating a long-term behavior of the battery deviation values over the measurement time.

11. The battery diagnosis method of claim 10, wherein the calculating of the moving average indicator comprises calculating an exponential moving average (EMA) of the battery deviation values to indicate the long-term behavior, and
the long-term behavior comprises a behavior of the battery deviation values in a period that is at least twice an analysis period of the EMA.

12. The battery diagnosis method of claim 11, wherein the diagnosing of the states of the diagnosis target cells comprises:
calculating deviation slopes based on a variance of the EMA in the period that is at least twice the analysis period; and
diagnosing the states of the diagnosis target cells based on the deviation slopes.

13. The battery diagnosis method of claim 8, wherein the calculating of the analysis indicator values comprises:
detecting a gap period in which there are no second battery measurement values satisfying the analysis condition among obtaining periods for obtaining the first battery measurement values; and
estimating analysis indicator values corresponding to the gap period by performing interpolation based on the analysis indicator values.

14. The battery diagnosis method of claim 8, wherein the diagnosis target cells are included in a diagnosis target battery, and the diagnosis target battery is mounted on a mobility device.

15. A battery diagnosis system comprising:
a diagnosis target battery comprising diagnosis target cells and mounted on a power-using device; and
a battery diagnosis apparatus configured to obtain first battery measurement values from diagnosis target cells, select second battery measurement values satisfying an analysis condition from among the first battery measurement values, calculate battery deviation values based on a difference between a representative value of the second battery measurement values and each of the second battery measurement values, calculate an analysis indicator value indicating a change trend with respect to a measurement time of the battery deviation values, and diagnose states of the diagnosis target cells based on the analysis indicator values.
